Europäisches Patentamt

European Patent Office

Office européen des brevets

(19)

(11) Numéro de publication : **0 098 191**
**B1**

(12) **FASCICULE DE BREVET EUROPÉEN**

(45) Date de publication du fascicule du brevet :
30.07.86

(51) Int. Cl.⁴ : **H 01 L 27/14, H 01 L 29/78**

(21) Numéro de dépôt : **83401194.2**

(22) Date de dépôt : **10.06.83**

(54) **Dispositif photosensible assurant un effet anti-éblouissement.**

(30) Priorité : 25.06.82 FR 8211205

(43) Date de publication de la demande :
11.01.84 Bulletin 84/02

(45) Mention de la délivrance du brevet :
30.07.86 Bulletin 86/31

(84) Etats contractants désignés :
DE GB SE

(56) Documents cités :
INTERNATIONAL CONFERENCE ON CHARGE COU-
PLED DEVICES, 29-31 octobre 1975, pages 85-91,
Edingburgh, GB. A.J. STECKL: "Injection efficiency in
hybrid IRCCD's"
IEEE TRANSACTIONS ON ELECTRON DEVICES, vol.
ED-27, no. 1, janvier 1980, pages 175-188, IEEE, New
York, USA P. FELIX et al.: "CCD readout of infrared
hybrid focal-plane arrays"

(73) Titulaire : **THOMSON-CSF**
**173, Boulevard Haussmann**
**F-75379 Paris Cedex 08 (FR)**

(72) Inventeur : **Arques, Marc**
**THOMSON-CSF SCPI 173, bld Haussmann**
**F-75379 Paris Cedex 08 (FR)**

(74) Mandataire : **Mayeux, Michèle et al**
**THOMSON-CSF SCPI 19, avenue de Messine**
**F-75008 Paris (FR)**

Jouve, 18, rue St-Denis, 75001 Paris, France

## Description

L'invention concerne le domaine des dispositifs photosensibles intégrés sur un substrat semiconducteur et plus particulièrement un dispositif photosensible assurant un effet anti-éblouissement.

L'un des inconvénients des dispositifs photosensibles est leur mauvaise résistance à l'éblouissement. Lorsqu'un point du dispositif se trouve trop intensément éclairé, les charges injectées en ce point peuvent se répartir dans tout le dispositif. Il y a donc perte d'une partie de l'image correspondant à la présence de charges parasites.

Pour supprimer cet inconvénient, il est connu d'utiliser des dispositifs anti-éblouissement (anti-blooming dans la littérature anglo-saxonne). Ces dispositifs absorbent les charges en excès. Le signal de lecture des points suréclairés est écrêté, mais le reste du dispositif photosensible n'est pas perturbé.

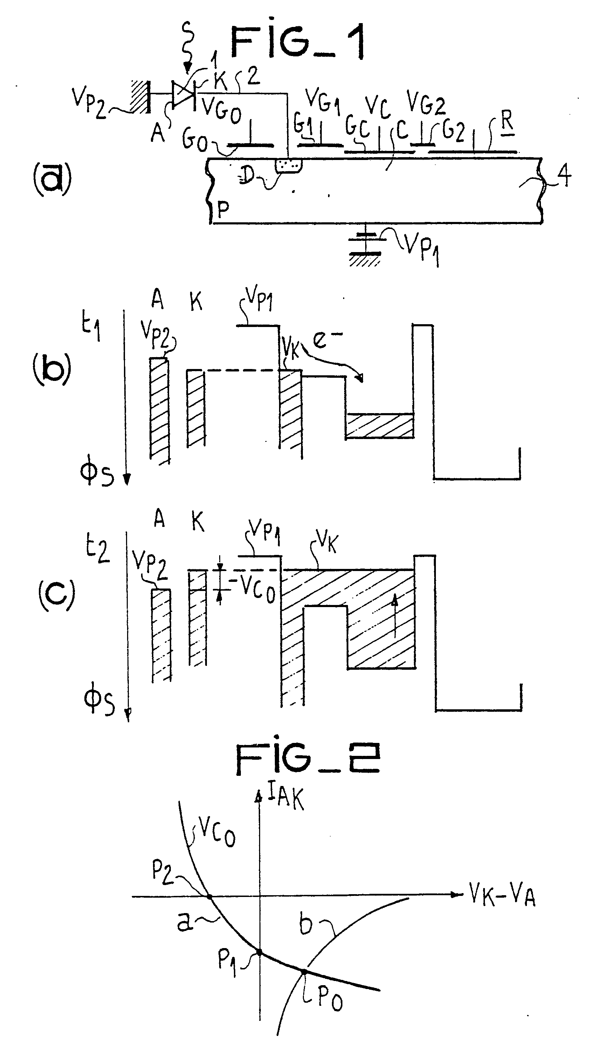

La structure de base d'un dispositif photosensible connu est représentée en figure 2 de la revue IEEE Transactions on Electron Devices vol. ED-27 n° 1 janvier 1980 pages 175-188.

Dans l'art antérieur, l'adjonction d'un dispositif anti-éblouissement à un dispositif photosensible complique sérieusement la structure de base du dispositif photosensible.

La présente invention concerne un dispositif photosensible assurant un effet anti-éblouissement et qui ne nécessite que peu de modifications de la structure de base du dispositif photosensible.

Selon la revendication 1, l'invention concerne un dispositif photosensible assurant un effet anti-éblouissement, comportant au moins un détecteur photosensible, chaque détecteur étant relié à une cellule d'intégration des charges, elle-même reliée à des moyens de lecture des charges, les détecteurs et les cellules d'intégration étant intégrés sur des substrats semi-conducteurs qui reçoivent des tensions de polarisation différentes, caractérisé en ce que :

chaque cellule d'intégration est entourée de moyens imposant, au moins pendant le temps d'intégration des charges, un potentiel de surface donné ;

les tensions de polarisation sont telles qu'en cas de suréclairement chaque détecteur ne débite plus de courant avant que le potentiel de surface de la cellule d'intégration ait atteint le potentiel de surface donné, ce qui produit un effet anti-éblouissement.

Pour que l'invention puisse s'appliquer, il est nécessaire de pouvoir polariser différemment le substrat semi-conducteur portant les détecteurs et celui portant les cellules d'intégration.

C'est le cas en particulier dans les dispositifs photosensibles pour la détection de l'infra-rouge où les détecteurs et les cellules d'intégration sont intégrés sur deux substrats différents. On utilise, par exemple, le tellurure de cadmium et de mercure ou l'antimoniure d'indium pour les détecteurs infra-rouge, et, par exemple, le silicium ou l'arséniure de gallium, pour les cellules d'intégration et les moyens de lecture.

La description suivante sera faite dans le cas d'un dispositif photosensible pour la détection de l'infra-rouge, utilisant deux substrats différents, mais il est bien entendu que l'invention s'applique aux dispositifs photosensibles pour la détection d'un rayonnement de longueur d'onde quelconque. Lorsque le dispositif photosensible est intégré sur un seul substrat semi-conducteur, il faut pouvoir polariser différemment la partie du substrat portant les détecteurs et celle portant les cellules d'intégration, en utilisant, par exemple, des caissons d'isolement.

Il faut signaler que l'invention assure un anti-éblouissement parfait au niveau de l'intégration du signal. Il ne peut y avoir débordement des charges d'une cellule d'intégration vers les cellules voisines. Dans l'un de ses modes de réalisation, l'invention assure également un anti-éblouissement parfait au niveau des moyens de lecture. On peut dimensionner les moyens de lecture en fonction de la quantité de charges maximum qui peut être transférée de chaque cellule d'intégration.

D'autres objets, caractéristiques et résultats de l'invention ressortiront de la description suivante, donnée à titre d'exemple non limitatif, et illustrée par les figures annexées qui représentent :

la figure 1a le schéma d'un mode de réalisation du dispositif selon l'invention, et les figures 1b, et c, des schémas représentant les potentiels de surface dans les substrats sur lesquels est intégré ce dispositif à deux instants $t_1$ et $t_2$ ;

la figure 2 les caractéristiques de la photodiode et du transistor MOS faisant partie de la cellule d'intégration des charges ;

les figures 3 et 4 des schémas équivalents au dispositif de la figure 1 ;

la figure 5 le schéma, vu de dessus, d'un mode de réalisation du dispositif selon l'invention ;

les figures 6a à f et 7a à e les schémas de deux modes de réalisation du dispositif selon l'invention et des schémas montrant l'évolution, en fonction du temps, du potentiel de surface dans le substrat ;

les figures 8a et b deux signaux d'horloge appliqués aux dispositifs selon l'invention représentés sur les figures 6a et 7a.

Sur les différentes figures, les mêmes repères désignent les mêmes éléments, mais, pour des raisons de clarté, les cotes et proportions des divers éléments ne sont pas respectées.

La figure 1a est le schéma d'un mode de réalisation du dispositif selon l'invention.

A titre d'exemple sur la figure 1a, le détecteur photosensible 1 qui est utilisé est une photodiode. L'invention s'applique quel que soit le détecteur infra-rouge utilisé, et donc aussi par exemple, lorsque le détecteur utilisé est du type grille-isolant-semi-conducteur.

L'anode A de la photodiode 1 reçoit une tension de polarisation $V_{P2}$. Sa cathode K est reliée par une connexion 2 à une cellule d'intégration des charges créées dans la photodiode 1 par le rayonnement à détecter, qui est symbolisé par une flèche ondulée.

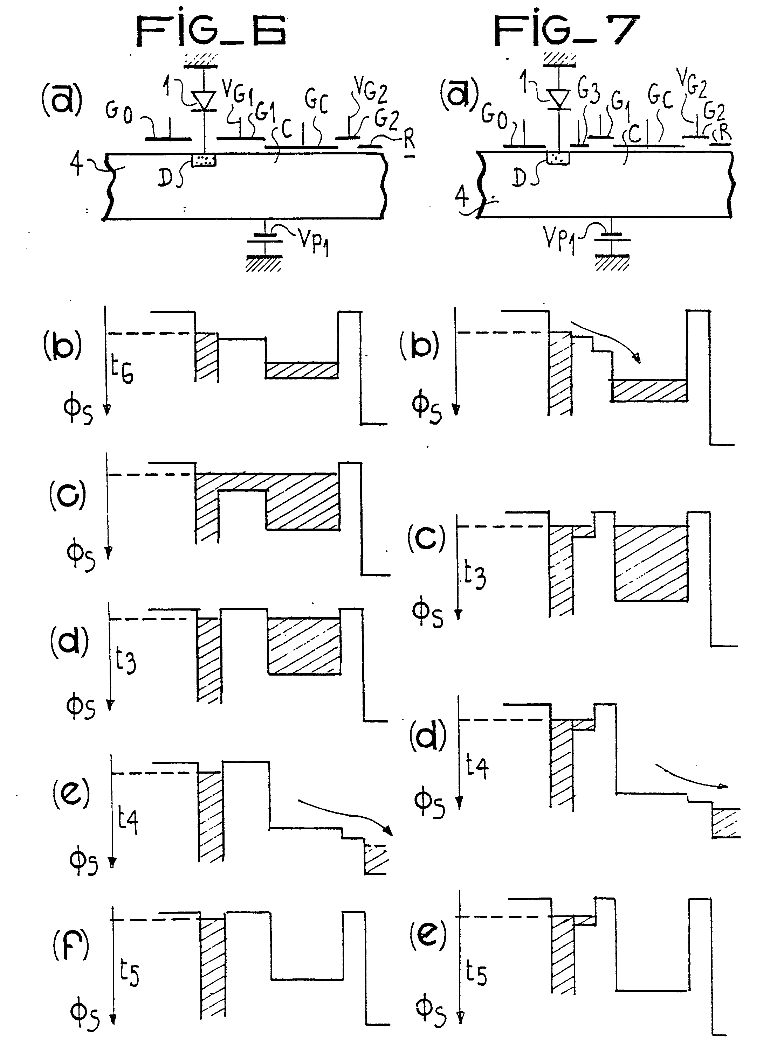

Comme cela est représenté sur la figure 5 qui est une vue de dessus d'un mode de réalisation du dispositif selon l'invention, les détecteurs photosensibles 1 sont intégrés sur un substrat semi-conducteur 3 différent de celui qui porte la référence 4 et sur lequel sont intégrées les cellules d'intégration des charges et le reste du dispositif photosensible. Le substrat semi-conducteur 4 reçoit une tension de polarisation $V_{P1}$.

L'invention concerne les dispositifs photosensibles comportant au moins un détecteur 1. Il est bien entendu que le dispositif selon l'invention peut comporter plusieurs détecteurs 1. Ces détecteurs peuvent être alignés comme sur la figure 5 ou, par exemple, disposés en matrice.

Chaque cellule d'intégration des charges comporte une diode D constituée sur la figure 1a par une zone de type N réalisée dans le substrat semi-conducteur 4, en silicium de type P, par exemple. Sur la figure 1a, cette diode D est reliée par une connexion 2 à la cathode K d'une photodiode 1. Une grille $G_1$ sépare chaque diode D d'une capacité C de stockage des charges, constituée par une grille $G_C$, une couche d'isolant et le substrat. Sur la figure 1a, par souci de clarté, on n'a pas représenté la couche d'isolant qui sépare les diverses grilles de la surface du substrat semi-conducteur 4. Une grille $G_2$ sépare chaque capacité C de moyens de lecture des charges. Ces moyens peuvent être constitués par un registre à décalages à transfert de charges R à entrées parallèles reliées aux cellules d'intégration et à sortie série reliée à un amplificateur qui n'est pas représenté.

On voit sur la figure 5 que des diffusions d'isolement 5, de même type que le substrat mais fortement dopées, délimitent longitudinalement chaque cellule d'intégration des charges. Ces cellules sont limitées transversalement par la grille $G_2$ et par une grille $G_0$, située à proximité des diodes D et séparée de la grille $G_1$ par les diodes D.

Le registre R joue le rôle d'un multiplexeur. Ainsi, il y a une seule connexion de sortie et un seul amplificateur est nécessaire.

On peut utiliser un multiplexeur réalisé autrement que par un registre à décalages à transfert de charges.

De même, il est possible d'utiliser des moyens de lecture comportant autant d'amplificateurs qu'il y a de détecteurs.

On va maintenant étudier le fonctionnement du dispositif selon l'invention.

Les figures 1b et c représentent le potentiel de surface dans les substrats 3 et 4 sur lesquels est intégré le dispositif, à deux instants $t_1$ et $t_2$.

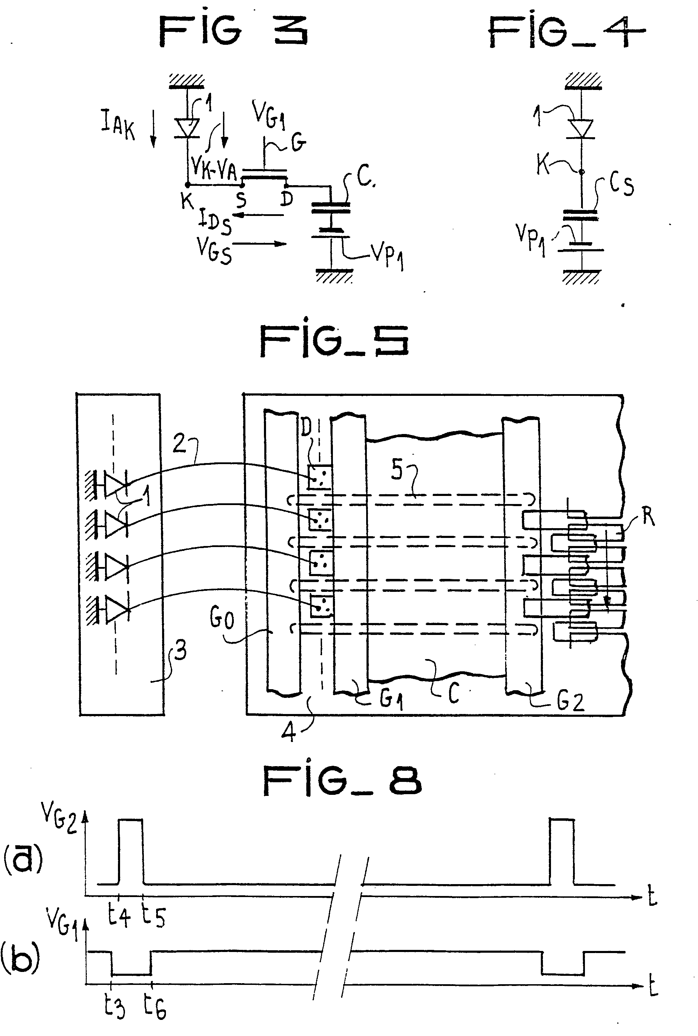

Les figures 3 et 4 sont des schémas équivalents du dispositif aux instants $t_1$ et $t_2$.

La figure 1b représente la situation en cas d'éclairement normal ou au début du temps d'intégration, s'il y a suréclairement. La diode D, la grille $G_1$ et la capacité C de chaque cellule d'intégration constituent un transistor MOS T dont la diode D est la source et dont la capacité C est le drain induit.

Ce transistor MOS est polarisé en régime de saturation car la tension continue $V_c$ appliquée à la grille $G_C$ est supérieure à la tension continue $V_{G1}$ appliquée à la grille $G_1$. Le niveau des charges sur la diode D s'aligne sur le potentiel constant existant sous la grille $G_1$. La cathode K de la photodiode reçoit une polarisation sensiblement constante et les charges créées dans le détecteur par le rayonnement sont stockées dans la capacité C, comme cela est représenté symboliquement sur la figure 1b, où les zones hachurées indiquent la présence de porteurs minoritaires par rapport au substrat 4.

Les diffusions d'isolement 5 qui limitent longitudinalement les cellules d'intégration imposent un potentiel de surface sensiblement égal à la tension de polarisation $V_{P1}$ du substrat 4.

On applique aux grilles $G_0$ et $G_2$ des tensions de polarisation $V_{G0}$ et $V_{G2}$ telles que, par exemple, le potentiel de surface sous ces grilles soit sensiblement égal à la tension de polarisation $V_{p1}$ du substrat 4. Ces tensions de polarisation doivent être telles que le transfert des charges ne puisse s'effectuer que de la diode D vers la capacité C.

A gauche sur la figure 1b, on a représenté les potentiels de l'anode et de la cathode de la photodiode 1. L'anode est au potentiel fixe $V_{P2}$, qui a été choisi égal à 0 Volt, et la cathode est à un potentiel positif imposé par la grille $G_1$.

La figure 3 est le schéma équivalent au dispositif de la figure 1a à l'instant $t_1$.

Le courant de la photodiode 1 charge à travers le transistor MOS T en saturation la capacité C.

Sur la figure 2, on a représenté en fonction du courant allant de l'anode vers la cathode $I_{AK}$ et de la différence de tension entre la cathode et l'anode $V_K - V_A$ les caractéristiques de la photodiode a et du transistor MOS T b. L'intersection de ces deux caractéristiques donne le point de fonctionnement $P_0$ du dispositif.

Tant que la capacité de stockage C n'est pas remplie, le point de fonctionnement reste en $P_0$.

La figure 1c représente les potentiels de surface à l'instant $t_2$, alors que la capacité de stockage est saturée. Les charges s'accumulent alors non seulement dans la capacité de stockage mais aussi sous la grille $G_1$, sur la diffusion d'entrée D et sur la connexion 2 entre la photodiode 1 et la diffusion D. La cellule d'intégration ne se comporte plus comme un transistor en régime de saturation mais comme une capacité $C_S$ qui est la somme de la capacité de stockage C, de la capacité existant sous $G_1$, de la capacité de la diffusion d'entrée D et de la capacité de la connexion 2 entre la photodiode et la diffusion d'entrée. La figure 4 représente le schéma équivalent du dispositif à l'instant $t_2$. La photodiode I charge la capacité $C_S$.

A partir de l'instant où la capacité de stockage C est saturée et où la cellule d'intégration ne se comporte plus comme un transistor MOS, le point de fonctionnement se déplace sur la caractéristique a de la photodiode. Il se trouve en $P_1$ lorsque la tension de polarisation $V_K$ de la cathode égale celle $V_A$ de l'anode. Si le suréclairement continue, le point de fonctionnement arrive en $P_2$, où il se fixe et où le niveau des charges dans la cellule d'intégration ne bouge plus. En $P_2$, la photodiode est polarisée à sa tension de circuit ouvert et elle ne débite plus de courant ($I_{AK} = 0$). Même si la photodiode continue à être suréclairée le niveau des charges reste fixe dans la cellule d'intégration.

On a donc réalisé un anti-éblouissement parfait pendant le temps d'intégration du signal. Il y a écrêtage du signal de sortie des points suréclairés mais il ne peut y avoir débordement des charges d'une cellule d'intégration vers les cellules voisines.

Sur la figure 1c à gauche, on voit qu'à l'instant $t_2$ la tension de polarisation de la cathode est devenue inférieure à celle de l'anode qui rappelons-le est fixe.

Pour que l'anti-éblouissement soit efficace, il faut d'une part que chaque cellule d'intégration soit entourée de moyens, qui peuvent être par exemple des grilles ou des diffusions d'isolement, qui imposent, au moins pendant le temps d'intégration des charges, un potentiel de surface donné, et d'autre part, il faut que les tensions de polarisation $V_{P1}$ et $V_{P2}$ soient différentes, et telles qu'en cas de suréclairement chaque détecteur se trouve polarisé à sa tension de circuit ouvert et ne débite plus de courant avant que le potentiel de surface de la cellule d'intégration ait atteint le potentiel de surface donné.

En général, comme dans l'exemple de la figure 1, le potentiel de surface donné est choisi sensiblement égal à la tension de polarisation $V_{P1}$ du substrat 4 sur lequel sont intégrées les cellules d'intégration des charges.

Par exemple dans le cas de la figure 1, on a choisi : $V_{P2} = 0V$ et $V_{P1}$ négatif égal par exemple à — 3 V. Ainsi la cellule d'intégration est limitée par des zones à un potentiel de — 3 V alors que le niveau des charges dans la cellule ne dépasse pas — $V_{co}$, qui est la tension de circuit ouvert de la photodiode et qui est égale à — 10 à — 50 mV environ.

Dans ce cas, on aurait pu appliquer à $G_0$ et $G_2$ des tensions de polarisation telles que ces grilles imposent un potentiel de surface de, par exemple, — 2 V ou — 1 V et en tous cas légèrement inférieur à — 50 mV. Le potentiel de surface donné n'est donc pas nécessairement égal à $V_{P1}$.

Dans un substrat semi-conducteur, le potentiel de surface qui peut être obtenu dépend de la tension de polarisation et du type du substrat. Ainsi dans le cas d'un substrat de type P polarisé à — 3 V, on ne peut obtenir un potentiel de surface inférieur à — 3 V. La tension de polarisa-tion $V_{P1}$ du substrat 4 doit donc être choisie en tenant compte de la tension de polarisation $V_{P2}$ du substrat 3 et de la tension de circuit ouvert des détecteurs. Lorsque le potentiel de surface donné est choisi sensiblement égal à la tension de polarisation $V_{P1}$ du substrat 4, il faut que la différence entre les tensions $V_{P1}$ et $V_{P2}$ soit au moins légèrement supérieure à la valeur absolue de $V_{CO}$. On détermine la valeur maximale que peut prendre $V_{CO}$ et il suffit que $V_{P1}$ — $V_{P2}$ soit, par exemple, supérieur d'1/10$^e$ de millivolts à $|V_{CO}|$. Cependant il est possible de choisir $V_{P1}$ — $V_{P2}$ très supérieur à $|V_{CO}|$.

La quantité de charges présentes dans l'étage d'entrée à la fin de la période d'intégration est donc parfaitement connue et limitée à la cellule d'intégration. Cette quantité de charges ne dépend, mises à part les tensions de polarisation du dispositif, que de la tension de circuit ouvert des photodiodes. Or cette tension dépend peu de l'éclairement des photodiodes et peut être majorée sans problèmes.

Le problème se pose maintenant de réaliser un anti-éblouissement parfait au niveau des moyens de lecture.

Pour transférer les charges stockées de la cellule d'intégration vers le registre R, on augmente, à la fin de la période d'intégration, la tension $V_{G2}$ appliquée à la grille $G_2$, comme cela est représenté sur la figure 8a.

Le niveau des charges dans la cellule d'intégration diminue et le point de fonctionnement se déplace de $P_2$ vers $P_0$. La photodiode se remet à débiter du courant. Les électrons qu'elle fournit traversent la cellule d'intégration et sont stockés, dans le registre R. Il peut donc arriver qu'à cause de la quantité de charges débitée par la photodiode durant le transfert des charges vers le registre, le registre se trouve saturé et son fonctionnement perturbé. Il faut cependant noter que la durée du transfert des charges est faible devant la durée de la période d'intégration des charges.

Pour éviter cela on diminue la tension $V_{G1}$ appliquée à la grille $G_1$, comme cela est représenté sur la figure 8b. Cette diminution se produit à un instant $t_3$ avant que se produise l'augmentation de $V_{G2}$ à l'instant $t_4$.

Les figures 6d et e représentent le potentiel de surface dans le substrat aux instants $t_3$ et $t_4$.

A l'instant $t_3$, la diffusion d'entrée D est isolée par la grille $C_1$ de la capacité de stockage C.

A l'instant $t_4$, la grille $G_2$ permet le transfert des charges stockées par la capacité C vers le registre R.

A l'instant $t_5$ — figure 6f — la tension $V_{G2}$ revient au niveau bas.

A l'instant $t_6$ — figure 6b — la tension $V_{G1}$ revient au niveau haut et une nouvelle période d'intégration des charges commence.

La tension $V_{G1}$ appliquée à la grille $G_1$ de $t_3$ à $t_5$ est telle que cette grille impose un potentiel de surface constant interdisant le transfert des charges de la diode D vers la capacité de stockage. Ce potentiel de surface peut être choisi sensiblement égal à $V_{P1}$.

Le registre à décalages est dimensionné pour pouvoir recevoir la quantité de charges maximum qui peut provenir de chaque capacité de stockage. Dans le mode de réalisation de la figure 6a, cette quantité de charges est égale à la quantité des charges maximum qui peut être stockée par chaque capacité de stockage des charges avant que le photodétecteur ne se trouve polarisé à sa tension de circuit ouvert.

Les figures 7a à e représentent le schéma d'un mode de réalisation du dispositif selon l'invention et des schémas montrant l'évolution du potentiel de surface dans le substrat à divers instants.

Ce mode de réalisation comporte, par rapport à celui représenté sur les figures 1a et 6a, une grille supplémentaire $G_3$ entre la diffusion d'entrée D et la grille $G_1$. La grille $G_3$ impose un potentiel de surface constant. Elle assure la polarisation de la cathode de la photodiode 1.

La grille $G_3$ est suivie par la grille $G_1$ qui pendant la période d'intégration impose un potentiel constant supérieur à celui imposé par $G_3$, la grille $G_1$ n'intervient donc pas dans la polarisation de la cathode K du détecteur. De $t_3$ à $t_5$, la tension $V_{G1}$ appliquée à la grille $G_1$ diminue et cette grille isole la diffusion d'entrée D de la capacité de stockage pendant le temps de transfert des charges.

La grille $G_3$ permet de fixer avec plus de précision le point de fonctionnement $P_1$ des détecteurs non suréclairés. En effet, la grille $G_3$ qui polarise la cathode du détecteur est en permanence à une tension constante, qu'il est plus facile de fixer avec précision, qu'une tension en créneaux comme celle qui est appliquée à la grille $G_1$. Par ailleurs, la grille $G_3$ joue le rôle d'écran pour protéger la diffusion d'entrée D des parasites créés par les impulsions appliquées sur la grille $G_1$.

Pour réaliser un anti-éblouissement parfait au niveau des moyens de lecture, il faut donc que chaque cellule d'intégration des charges comporte des moyens qui, d'une part, participent à la polarisation du détecteur et qui, d'autre part, à la fin du temps d'intégration des charges, interdisent le transfert de charges en provenance de la diode D.

Les figures 6a et 7a montrent deux modes de réalisation de l'invention où ces moyens sont constitués par la grille $G_1$ et par les grilles $G_3$ et $G_1$.

La description précédente a été faite dans le cas de photodiodes ayant une anode commune, mais l'invention s'applique aussi dans le cas où les photodiodes ont leur cathode commune. De même, le substrat 4 sur lequel sont réalisées les cellules d'intégration, et éventuellement les moyens de lecture, peut être de type P ou N. Lorsque les photodiodes ont leur anode commune, le substrat doit être de type P. Lorsque les photodiodes ont leur cathode commune, le substrat doit être de type N. La grille $G_0$ peut être remplacée par une diffusion d'isolement et les diffusions d'isolement 5 peuvent être remplacées par des grilles.

## Revendications

1. Dispositif photosensible assurant un effet anti-éblouissement, comportant au moins un détecteur photosensible (1), chaque détecteur étant relié à une cellule d'intégration des charges, elle-même reliée à des moyens de lecture des charges, les détecteurs (1) et les cellules d'intégration étant intégrés sur des substrats semi-conducteurs (3, 4) qui reçoivent des tensions de polarisation ($V_{P2}$, $V_{P1}$) différentes, caractérisé en ce que :
chaque cellule d'intégration est entourée de moyens imposant, au moins pendant le temps d'intégration des charges, un potentiel de surface donné ;
les tensions de polarisation ($V_{P2}$, $V_{P1}$) sont telles qu'en cas de suréclairement chaque détecteur ne débite plus de courant avant que le potentiel de surface de la cellule d'intégration ait atteint le potentiel de surface donné, ce qui produit un effet anti-éblouissement.

2. Dispositif selon la revendication 1, caractérisé en ce que le potentiel de surface donné est sensiblement égal à la tension de polarisation ($V_{P1}$) du substrat (4) sur lequel est intégrée chaque cellule d'intégration.

3. Dispositif selon l'une des revendications 1 ou 2, caractérisé en ce que chaque cellule d'intégration des charges comporte :
une diode (D) reliée au détecteur (1) ;
une capacité de stockage des charges (C) ;
des premiers moyens participant à la polarisation du détecteur ;
des seconds moyens, positionnés entre la capacité de stockage (C) et les moyens de lecture, qui imposent, pendant le temps d'intégration des charges, un potentiel de surface égale au potentiel de surface donné et qui imposent, à la fin du temps d'intégration des charges, un potentiel de surface permettant le transfert des charges vers les moyens de lecture.

4. Dispositif selon la revendication 3, caractérisé en ce que, à la fin du temps d'intégration des charges, les premiers moyens interdisent le transfert de charges en provenance de la diode (D), et en ce que les moyens de lecture sont dimensionnés pour recevoir la quantité de charges maximum pouvant provenir de la capacité de stockage (C).

5. Dispositif selon l'une des revendications 3 ou 4, caractérisé en ce que les premiers moyens comportent au moins une grille ($G_1$, $G_3$) qui impose pendant le temps d'intégration des charges un potentiel de surface tel que par rapport au potentiel de surface existant sous la capacité de stockage le transistor MOS constitué par la diode (D) reliée au détecteur, la grille ($G_1$, $G_3$) des premiers moyens et la capacité de stockage (C) soit d'abord polarisé en régime de saturation, avant éventuellement de quitter ce régime s'il y a suréclairement.

6. Dispositif selon la revendication 3, caractérisé en ce que les premiers moyens sont constitués par une première grille ($G_1$), placée entre la

diode (D) et la capacité de stockage des charges (C), cette première grille imposant un potentiel de surface constant en permanence.

7. Dispositif selon la revendication 4, caractérisé en ce que les premiers moyens sont constitués par une première grille (G₁), placée entre la diode (D) et la capacité de stockage des charges (C), cette première grille imposant, pendant le temps d'intégration des charges, un premier potentiel de surface constant, qui participe à la polarisation du détecteur et cette première grille imposant, à la fin du temps d'intégration des charges, un second potentiel de surface constant qui interdit le transfert des charges en provenance de la diode (D) vers la capacité de stockage (C).

8. Dispositif selon la revendication 4, caractérisé en ce que les premiers moyens comportent, entre la diode (D) et la capacité de stockage (C) de chaque cellule d'intégration, une troisième grille (G₃) qui impose un potentiel de surface constant et qui participe à la polarisation du détecteur, cette troisième grille étant suivie par une première grille (G₁) qui, pendant le temps d'intégration des charges, impose un premier potentiel de surface constant permettant le transfert des charges de la diode vers la capacité de stockage et qui, à la fin du temps d'intégration des charges, impose un second potentiel de surface constant interdisant ce transfert.

9. Dispositif selon l'une des revendications 7 ou 8, caractérisé en ce que le second potentiel de surface constant imposé par la première grille (G₁) est sensiblement égal à la tension de polarisation (V$_{P1}$) du substrat (4) sur lequel elle est intégrée.

10. Dispositif selon l'une des revendications 3 à 9, caractérisé en ce que les seconds moyens sont constitués par une deuxième grille (G₂).

11. Dispositif selon l'une des revendications 1 à 10, caractérisé en ce que les moyens qui entourent chaque cellule d'intégration des charges sont constitués d'une part, par la deuxième grille (G₂) et d'autre part par des grilles (G₀) ou/et par des diffusions d'isolement (5) de même type que le substrat (4).

12. Dispositif selon l'une des revendications 1 à 11 caractérisé en ce que les moyens de lecture sont constitués par un registre à décalages à transfert de charge (R) à entrées parallèles reliées aux cellules d'intégration et à sortie série reliée à un amplificateur.

13. Dispositif selon l'une des revendications 1 à 12, caractérisé en ce que les détecteurs (1) sont des détecteurs du type grille-isolant-semi-conducteur.

14. Dispositif selon l'une des revendications 1 à 13, caractérisé en ce que l'ensemble du dispositif photosensible est intégré sur le même substrat semi-conducteur.

15. Dispositif selon l'une des revendications 1 à 13, caractérisé en ce que les détecteurs sont des détecteurs infra-rouge et sont réalisés sur un substrat différent de celui sur lequel sont réalisées les cellules d'intégration.

16. Dispositif selon l'une des revendications 1 à 15, caractérisé en ce que les détecteurs (1) sont des photodiodes et en ce qu'en cas de suréclairement chaque détecteur se trouve polarisé à sa tension de circuit ouvert.

**Claims**

1. Photosensitive device ensuring an anti-glaring effect, comprising at least one photosensitive detector (1), each detector being connected to a load integration cell which is in turn connected to load reading means, the detectors (1) and the integration cells being integrated on semi-conductor substrates (3, 4) receiving different polarization voltages (V$_{P2}$, V$_{P1}$), characterized in that :

each integration cell is surrounded by means imposing at least during the load integration time a given surface potential ;

the polarization voltages (V$_{P2}$, V$_{P1}$) being such that in case of overexposure each detector supplies no more current before the surface potential of the integration cell has reached the given surface potential, thus producing an anti-glaring effect.

2. Device according to claim 1, characterized in that the given surface potential is substantially equal to the polarization voltage (V$_{P1}$) of the substrate (4) whereupon each integration cell is integrated.

3. Device according to any of claims 1 and 2, characterized in that each load integration cell comprises :

a diode (D) connected to the detector (1) ;

a load storage capacitor (C) ;

first means contributing to the polarization of the detector ;

second means positioned between the storage capacitor (C) and the reading means and imposing during the load integration time a surface potential equal to the given surface potential and imposing at the end of the load integration time a surface potential permitting the transfer of the loads to the reading means.

4. Device according to claim 3, characterized in that at the end of the load integration time the first means inhibit the transfer of loads from the diode (D) and in that the reading means are dimensioned to receive the maximum quantity of loads susceptible to be supplied by the storage capacitor (C).

5. Device according to any of claims 3 and 4, characterized in that the first means comprise at least one gate (G₁, G₃) imposing during the load integration time a surface potential such that, with respect to the surface potential existing beneath the storage capacitor, the MOS transistor formed by the diode (D) connected to the detector, the gate (G₁, G₃) of the first means and the storage capacitor (C), is first of all polarized in its saturation condition prior to eventually leaving this condition if there is an overexposition.

6. Device according to claim 3, characterized in that the first means are formed by a first gate

($G_1$) located between the diode (D) and the load storage capacitor (C), this first gate permanently imposing a constant surface potential.

7. Device according to claim 4, characterized in that the first means are formed by a first gate ($G_1$) located between the diode (D) and the load storage capacitor (C), this first gate imposing during the load integration time a first constant surface potential contributing to the polarization of the detector and this first gate imposing at the end of the load integration time a second constant surface potential inhibiting the transfer of the loads from the diode (D) to the storage capacitor (C).

8. Device according to claim 4, characterized in that the first means comprise between the diode (D) and the storage capacitor (C) of each integration cell a third gate ($G_3$) imposing a constant surface potential and contributing to the polarization of the detector, this third gate being followed by a first gate ($G_1$) imposing during the load integration time a first constant surface potential permitting the transfer of loads from the diode to the storage capacitor and imposing at the end of the load integration time a second constant surface potential inhibiting this transfer.

9. Device according to any of claims 7 and 8, characterized in that the second constant surface potential imposed by the first gate ($G_1$) is substantially equal to the polarization voltage ($V_{P1}$) of the substrate (4) whereupon it is integrated.

10. Device according to any of claims 3 to 9, characterized in that the second means are formed by a second gate ($G_2$).

11. Device according to any of claims 1 to 10, characterized in that the means which surround each load integration cell are formed by a second gate ($G_2$) on the one hand and by gates ($G_0$) or/and by insulation diffusions (5) of the same type as the substrate (4), on the other hand.

12. Device according to any of claims 1 to 11, characterized in that the reading means are formed by a load transfer shift register (R) having parallel inputs connected to the integration cells and a serial output connected to an amplifier.

13. Device according to any of claims 1 to 12, characterized in that the detectors (1) are detectors of the type gate-insulation-semiconductor.

14. Device according to any of claims 1 to 13, characterized in that the entire photosensitive device is integrated on the same semiconductor substrate.

15. Device according to any of claims 1 to 13, characterized in that the detectors are infrared detectors and formed on a substrate different from that whereupon the integration cells are formed.

16. Device according to any of claims 1 to 15, characterized in that the detectors (1) are photodiodes and in that each detector is polarized to its open circuit voltage in case of overexposure.

## Patentansprüche

1. Fotoempfindliche Vorrichtung, welche einen Anti-Blendeffekt gewährleistet, mit wenigstens einem fotoempfindlichen Detektor (1), wobei jeder Detektor an eine Ladungsintegrationszelle angeschlossen ist, die ihrerseits an Ladungslesemittel angeschlossen ist, wobei die Detektoren (1) und die Integrationszellen auf Halbleitersubstraten (3, 4) integriert sind, welche verschiedene Polarisationsspannungen ($V_{P2}$, $V_{P1}$) empfangen, dadurch gekennzeichnet, daß :

jede Integrationszelle von Mitteln umgeben ist, welche wenigstens während der Ladungsintegrationszeit ein gegebenes Oberflächenpotential auferlegen ;

die Polarisationsspannungen ($V_{P2}$, $V_{P1}$) derart sind, daß im Falle einer Überbelichtung jeder Detektor keinen Strom mehr abgibt, bevor das Oberflächenpotential der Integrationszelle das gegebene Oberflächenpotential erreicht hat, wodurch ein Anti-Blendeffekt erzeugt wird.

2. Vorrichtung nach Anspruch 1, dadurch gekennzeichnet, daß das gegebene Oberflächenpotential im wesentlichen gleich der Polarisationsspannung ($V_{P1}$) des Substrates (4) ist, auf welchem jede Integrationszelle integriert ist.

3. Vorrichtung nach Anspruch 1 oder 2, dadurch gekennzeichnet, daß jede Ladungsintegrationszelle umfaßt :

eine mit dem Detektor (1) verbundene Diode (D) ;

eine Ladungsspeicherkapazität (C) ;

erste Mittel, welche zur Polarisation des Detektors beitragen ;

zweite Mittel, welche zwischen der Speicherkapazität (C) und den Lesemitteln angeordnet sind sowie während der Ladungsintegrationszeit ein Oberflächenpotential auferlegen, das gleich dem gegebenen Oberflächenpotential ist, und am Ende der Ladungsintegrationszeit ein Oberflächenpotential auferlegen, welches die Überführung der Ladungen zu den Lesemitteln gestattet.

4. Vorrichtung nach Anspruch 3, dadurch gekennzeichnet, daß am Ende der Ladungsintegrationszeit die ersten Mittel die Überführung von Ladungen, die von der Diode (D) herrühren, unterbinden und daß die Lesemittel zum Empfangen der maximalen Ladungsmenge dimensioniert sind, welche von der Speicherkapazität (C) herrühren kann.

5. Vorrichtung nach Anspruch 3 oder 4, dadurch gekennzeichnet, daß die ersten Mittel wenigstens ein Gate ($G_1$, $G_3$) umfassen, welches während der Ladungsintegrationszeit ein solches Oberflächenpotential auferlegt, daß gegenüber dem Oberflächenpotential, welches unter der Speicherkapazität vorhanden ist, der MOS-Transistor, welcher gebildet ist aus der mit dem Detektor verbundenen Diode (D), dem Gate ($G_1$, $G_3$) der ersten Mittel und der Speicherkapazität (C), zunächst in Sättigung polarisiert ist, bevor er gegebenenfalls diesen Zustand verläßt, wenn eine Überbelichtung stattfindet.

6. Vorrichtung nach Anspruch 3, dadurch gekennzeichnet, daß die ersten Mittel durch ein erstes Gate ($G_1$) gebildet sind, welches zwischen der Diode (D) und der Ladungsspeicherkapazität (C) angeordnet ist, wobei dieses erste Gate ein dauernd konstantes Oberflächenpotential auferlegt.

7. Vorrichtung nach Anspruch 4, dadurch gekennzeichnet, daß die ersten Mittel aus einem ersten Gate (G₁) gebildet sind, welches zwischen der Diode (D) und der Ladungsspeicherkapazität (C) angeordnet ist sowie während der Ladungsintegrationszeit ein erstes konstantes Oberflächenpotential auferlegt, welches zur Polarisation des Detektors beiträgt, und wobei das erste Gate am Ende der Ladungsintegrationszeit ein zweites konstantes Oberflächenpotential auferlegt, welches die Überführung von Ladungen aus der Diode (D) zu der Speicherkapazität (C) unterbindet.

8. Vorrichtung nach Anspruch 4, dadurch gekennzeichnet, daß die ersten Mittel zwischen der Diode (D) und der Speicherkapazität (C) jeder Integrationszelle ein drittes Gate (G₃) umfassen, welches ein konstantes Oberflächenpotential auferlegt und an der Polarisation des Detektors teilnimmt, wobei auf dieses dritte Gate ein erstes Gate (G₁) folgt, welches während der Ladungsintegrationszeit ein erstes konstantes Oberflächenpotential auferlegt, das die Überführung der Ladungen aus der Diode zu der Speicherkapazität zuläßt, und am Ende der Ladungsintegrationszeit ein zweites konstantes Oberflächenpotential auferlegt, welches diese Überführung unterbindet.

9. Vorrichtung nach Anspruch 7 oder 8, dadurch gekennzeichnet, daß das zweite konstante Oberflächenpotential, welches durch das erste Gate (G₁) auferlegt wird, im wesentlichen gleich der Polarisationsspannung ($V_{P1}$) für das Substrat

(4) ist, worauf es integriert ist.

10. Vorrichtung nach einem der Ansprüche 3 bis 9, dadurch gekennzeichnet, daß die zweiten Mittel durch ein zweites Gate (G₂) gebildet sind.

11. Vorrichtung nach einem der Ansprüche 1 bis 10, dadurch gekennzeichnet, daß die Mittel, welche jede Ladungsintegrationszelle umgeben, einerseits durch das zweite Gate (G₂) und andererseits durch Gates (G₀) oder/und durch Isolierdiffusionen (5) gleichen Typs wie das Substrat (4) gebildet sind.

12. Vorrichtung nach einem der Ansprüche 1 bis 11, dadurch gekennzeichnet, daß die Lesemittel durch ein Ladungsüberführungs-Schieberegister (R) mit parallelen Eingängen, welche mit den Integrationszellen verbunden sind, und mit einem seriellen Ausgang, welcher an einen Verstärker angeschlossen ist, gebildet sind.

13. Vorrichtung nach einem der Ansprüche 1 bis 12, dadurch gekennzeichnet, daß die Detektoren (1) solche vom Typ Gate-Isolierstoff-Halbleiter sind.

14. Vorrichtung nach einem der Ansprüche 1 bis 13, dadurch gekennzeichnet, daß die gesamte fotoempfindliche Vorrichtung auf demselben Halbleitersubstrat integriert ist.

15. Vorrichtung nach einem der Ansprüche 1 bis 13, dadurch gekennzeichnet, daß die Detektoren Infrarotdetektoren sind sowie auf einem Substrat verwirklicht sind, das verschieden von dem ist, auf welchem die Integrationszellen hergestellt sind.

16. Vorrichtung nach einem der Ansprüche 1 bis 15, dadurch gekennzeichnet, daß die Detektoren (1) Fotodioden sind, und daß im Falle einer Überbelichtung jeder Detektor auf seine Spannung bei geöffnetem Kreis polarisiert ist.

FIG_1

FIG_2

# FIG 3

# FIG_4

# FIG_5

# FIG_8

(a)

(b)

2

# FIG_6

## FIG_7